# EUROPEAN PATENT SPECIFICATION

(11) **EP 0 427 551 B1**
(45) Date of publication and mention of the grant of the patent: **29.03.1995**
(21) Application number: 90312230.7
(22) Date of filing: 08.11.1990
(51) Int. Cl.: G01R 29/24, G01R 31/12

(54) **A process and apparatus for testing the condition of an insulating system**
Verfahren und Apparatur zur Untersuchung des Zustandes eines Isolationssystems
Procédé et appareil pour tester la condition d'un système d'isolation

(30) Priority: 09.11.1989 HU 584389
(43) Date of publication of application: 15.05.1991
(73) Proprietor: B & C Diagnostics Kft, Budapest (HU)
(72) Inventor: Bognar, Alajos, Kiscelli u. 77 (HU); Csépes, Gusztav, Vaci u.52/b (HU); Hamos, Istvan, Rakoczi u. 25 (HU); Kalocsai, Laszlo, Taller u. 12 (HU); Schmidt, Janos, Paskompark 3 (HU)
(74) Representative: Gold, Tibor Z.

(56) References cited:
- JAPANESE JOURNAL OF APPLIED PHYSICS. vol. 21, no. 9, September 1982, TOKYO JP pages 1333 - 1336; K.Yoshino et.al.: "Residual voltage in Polyethylene"
- JAPANESE JOURNAL OF APPLIED PHYSICS. vol. 23, no. 6, June 1984, TOKYO JP pages 741 - 747; S.Yamanaka et.al.: "Residual voltage in low-density Polyethylene film containing antioxidant"
- Elektrotechnische Zeitschrift A vol. 95, no. 1, 1974, pages 21 - 25; K.-B.Müller: "Die Ausbildung von Raumladungen und deren Einfluss auf den Durchschlag bei Polyäthlenkabeln unter hohen Gleichspannungen"
- ELECTRONICS TEST. vol. 12, no. 3, March 1989, SAN FRANCISCO US pages 52 - 62; A.O.Reynolds: "High-voltage insulation testing protects factory floor equipment"

## Description

The invention concerns a process and apparatus for testing the condition of an insulating system in which the insulating system is charged up with direct charging voltage through electrically conducting parts which are insulated from each other, then it is discharged and the condition of the insulating system is determined from parameters of the recovery voltage.

Information gained from the determination of the state or condition of insulation is of great importance in assessing the reliability of operation of electrical machinery, especially high-voltage (HV) electrical equipment. The condition of the electrical insulation can be determined by measuring different physical (electrical) and chemical characteristics. These characteristics change with operational demands and stresses, and from a measure of the changes conclusions can be drawn about the degree of deterioration of the electrical insulation.

Japanese Journal of Applied Physics, Volume 21 (1982), No. 9, Part 1, pages 1333-1336 discloses an investigation of the degration of polyethylene film providing insulating for a power cable by a relatively simple measurement procedure. A voltage Vₐ is applied to a film sample for a time Tₐ, after which the system is short-circuited for a time Tₛ. A residual voltage Vᵣ is thereby generated after a time T. The effects on the residual voltage Vᵣ of varying respectively the applied voltage Vₐ, the voltage application time Tₐ and the short-circuiting time Tₛ are thereby investigated. In each case, a simple function is plotted for freshly prepared polyethylene film for providing a computer simulation for comparison when measurements are taken from potentially degraded polyethylene film.

Hereafter, the term "insulating system" refers to insulating for electrical equipment consisting of several layers of insulating material. Its deterioration may be of two different kinds:
1. local deterioration or failure; and
2. general deterioration extending in the bulk of insulating system.

Hereafter, we will discuss chiefly the possibilities of detection of general deterioration in insulating systems by the use of non-destructive tests. From a point of view of the state of electrical insulation the detection of two kinds of change is of great importance:
a. the insulation becoming more and more wet; and
b. accumulation of by-products of decomposition caused by deterioration at high temperatures.

Of these, phenomenon a. is especially significant. According to the results of research (IEE Proceedings, Vol. 132, Pt. C. No. 6, November 1985, pp 312-319 in a paper entitled "A review of paper aging in power transformers), when the moisture content of insulating paper increases to 2%, the service life of an oil-paper insulating system is decreased to about 1/20th of the dry insulation.

The known processes of testing insulating systems include a determination of the insulation resistance, the absorption factor and the loss factor. The theoretical basis and the first testing apparatus were developed more than 70 years ago. Despite improvements since then in the design of testing apparatus involving electronic circuitry, the information that can be gained from such test methods is of limited use.

The measurement of insulation resistance is one of the oldest method of insulation testing. Its advantage is its simple procedure but its disadvantage is the rather low information content. The value of insulation resistance is influenced not only by the above-mentioned two important kinds of change in the insulation, but also by many other parameters, among these the geometrical dimensions of the test object. The relation of the insulation resistance to the mentioned kinds of change a. and b. is not unambiguous, and a significant alteration is generally caused only by a significant deterioration. The test results are appreciably influenced by the condition of the external insulation which puts a query against the simplicity of the testing.

The introduction of the absorption coefficient (K_{A}=R₆₀/R₁₀), where the numbers denote the elapsed time after the application of a DC voltage at which the insulation resistance is measured, was promoted by two factors:
1. a demand for a characteristic not depending on the geometrical sizes, and
2. the experience according to which the insulation resistance depends on the time when voltage is read off during the measurement, namely the value of the measured insulation resistance is influenced by the polarization phenomena developing in the insulating system. The evaluation of absorption coefficient follows rules of thumb: if the value of K_{A} is between 2...2.5 then the condition of the insulating system can be regarded as good, if it is about 1 then it is bad.

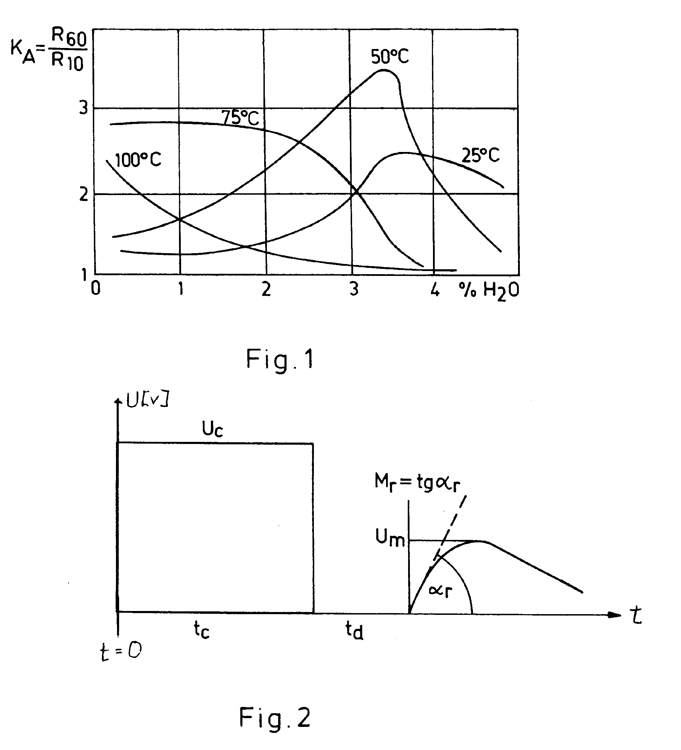

According to the inventors' investigations the relation between the absorption coefficient and the condition of the insulating system cannot be assessed in such a simple way. This can be seen in Fig. 1 where K_{A}=R₆₀/R₁₀ is plotted against the moisture content of oil-paper insulating system, at different temperatures. The validity of the assessment mentioned above may be strongly disputed: the absorption coefficient is not changing monotonously as a function of the moisture content. The disadvantage of this method is the fact that it measures the superimposition of conduction and polarization phenomena, hence its sensitivity is rather limited.

The determination of loss factor (tanδ) has been used for more than 60 years to assess the condition of electrical insulation in service. The value of the loss tangent is influenced by both conduct ion and polarization losses in the insulation. The sensitivity of the reaction of the loss tangent to particular kinds of polarization phenomena is mainly influenced by the frequency of the measurement voltage. Processes taking place due to ageing of an insulating system have a strong influence primarily on the polarization phenomena with a long time-constant; arising from this, measurements carried out with a voltage of very low frequency (VLF) would be the most sensitive. However, a practical (on-site) realization of this kind VLF loss factor measurement has not been developed yet. When measuring tanδ at 50 Hz, a significant change can in general be detected only when the insulating system has very strongly deteriorated. It has to be mentioned that on-site measuring of tanδ in a high voltage substation is a rather complicated process because of strong scattered electrical fields which have a disturbing effect.

The above-mentioned traditional methods of insulation testing are of extremely limited usefulness because they tend to characterize the condition of a very complicated insulating system by a single number or measurement parameter, which is evidently not only insufficient, but is also full of contradictions.

In spite of these facts, even at the present level of modern measurement technology, only the above-mentioned methods are used for testing electrical equipment in service, as may be seen from the test results on transformers of 132 kV in the United Kingdom, see Domun-Cornfeld-Hadfield: Prediction of remaining lives of 132 kV grid transformers, CIGRE Symposium, Section 10.2, No. 1020-08, May 1987, Vienna.

The phenomenon of the appearance of a recovery voltage following charging up by DC voltage, then discharging has been known for a long time under the name of "electrical after-effect". As is described in a Hungarian textbook "High Voltage Engineering", by András Csernátonyi Hoffer and Tibor Horváth, Tankönyvkiadó, 1986, p. 260-65, the practical importance of this phenomenon is this: apparatus and equipments of high capacitance which have been charged up by DC and then switched off, should in practice be short-circuited for a long time or at all times. The electrical after-effect, i.e. the recovery voltage evidently contains information relating to the condition or state of insulation. This is referred to in the literature mentioned, moreover, its theoretical explanation may also be found in it.

The recovery voltage, or rather its parameters, can give reliable and full information on the state of insulation only when the broad range of polarization phenomena of long time-constant can be determined.

It is known that predetermined values of the charging and discharging times activate a certain band of elementary polarization processes characterizable by a range of time-constants.

Hitherto no test method and apparatus applicable in a broad field have been known.

An aim of this invention has been to find a test method and apparatus to determine polarization distribution in the domain of space-charge polarization phenomena of long time-constant which are unambiguously related to the state, and change of state, of an insulating system, by evaluating the parameters of the recovery voltage appearing after charging the insulating system by DC voltage and discharging it for a certain time.

According to this invention there is provided a process for testing the condition of an insulating system, comprising charging the insulating system with a direct charging voltage through insulated, electrically conducting parts, then discharging the insulating system, and determining the condition of the insulating system from the parameters of the recovery voltage, characterised by selecting the duration of charging to be in the range of 10⁻³ - 10⁴s and the ratio of charging period to discharging period to be in the range of 0.1 to 100, measuring the ratio of the peak value of the recovery voltage to the charging voltage, and then repeating the measurement with different durations, but a constant ratio, of the charging-discharging periods, determining the distribution of the said voltage ratios as a function of the charging period, and determining the state of the insulating system by comparing the thus obtained distribution with a reference distribution.

The process according to the invention has the advantage that it is possible to take measurements in the low frequency range, i.e. using a broad time interval in the whole polarization domain with a long time-constant, and thereby obtain relevant information regarding the deterioration of the insulating system, and that by an expedient selection of ratio of charging/discharging time the desired resolution may also be reached. This is because we have recognized that there is an unambiguous relationship between the shape of the polarization distribution determined by the peak value of the recovery voltage and the humidity content of the insulating system.

We recognized further that the distribution of a new insulating system determined in the above-mentioned way can be regarded as a reference and this distribution is modified by the changes resulting from ageing of the insulation.

According to an advantageous implementation of the method of this invention the initial slope of the recovery voltage can be determined as a function of charging time and thus a distribution can be built up, the state of the insulating system can be further assessed by comparing this distribution with a further reference distribution. We recognized that the distribution of the initial slope is also well able to characterize the state of insulating system and reacts sensitively to the changes influencing the polarization phenomena of long time-constant.

In order to enable a measurement of the initial slope with a small error by suppressing disturbances at mains frequency, according to a further advatnageous implementation of method of this invention, the initial slope is determined by sampling the voltage at which the cycle time of the sampling is equal to the cycle time of the AC main or to its integral multiple.

Any of the implementations of the method according to this invention may be supplemented by measuring the charging current as a function of time after the application of DC charging voltage. In this way, the time-function of insulating resistance can be determined. The advantage of this implementation possibility is to give another insulation characteristic within the same testing process, because the absorption coefficient K_{A} can be calculated, the determination of which is prescribed in several standards.

For the implementation of the method according to this invention a preferred apparatus comprises a high voltage source and voltage measuring circuitry, one voltage terminal of the high voltage source being connected to a first measurement terminal of the apparatus while the other voltage terminal of the high voltage source is connected via a first serial branch switch to a second measurement terminal thereof, and the voltage measuring circuitry including a recovery voltage measuring unit connected via one of its connection terminals to the first measurement terminal, which first measurement terminal is connected or connnectable to a first insulated, electrically conducting part of the insulating system to be tested, characterised in that another insulated, electrically conducting part of the insulating system is connected to the second measurement terminal, the other voltage terminal of the high voltage source being connected to the second measurement terminal via the first and a second serial branch switch; in that a transverse shunt switch is inserted after the first serial branch switch between the first measurement terminal and a common node of the two serial branch switches; in that the other connection terminal of the measuring unit is connected, preferably via at least one further serial branch switch, to the second measurement terminal; in that a further transverse shunt switch is connected in parallel with said measuring unit; and in that, preferably, the said switches are solid state switches.

The advantages of such apparatus are a compact design and easy handling. The transverse branch switch inserted after the first series branch switch makes it possible to eliminate the effect of occasional leakage of both switches in the series branch.

In one further advantageous realisation of the apparatus according to this invention, the connection of the second measuring terminal and the said other electrode of the said insulating system is effected by means of the inner lead of a double-screened cable; and in that said measuring unit consists of an electrometer circuit, an outlet of which is connected via a series switch to the inner shield of said cable with the other shield of said cable being connected to earth potential.

By this advantageous arrangement the errors caused by the capacity and leakage of connection between the measuring system and the insulating system can be eliminated.

In another advantageous realisation of the apparatus according to this invention a switch is connected between the inner lead and the inner shield; in addition, the input resistance of the recovery voltage meter unit may be at least 2x10¹³ ohm. As a consequence of these measures the compensation of the connecting lead is realized only during the actual measurement time, while the high input resistance increases the accuracy of testing.

In a further advantageous embodiment of the apparatus according to this invention a current measuring unit is inserted between the high voltage source and one of the measuring terminals. By this means possibility is given to measure, not only the recovery voltage parameters, but also the insulation resistance as a function of time, whereby the absorption coefficient can be determined.

Preferably, the switches are of solid state design. By using these, the drawbacks of mechanical switches (dead time, backlash of contacts, etc) can be eliminated.

The method and apparatus according to the invention are described in greater detail, purely by way of example, with reference to the accompanying drawings, wherein:
Fig. 1 is a diagram showing the change of the absorption coefficient K_{A}=R₆₀/R₁₀, as a function of the humidity of the paper and the temperature, in the case of an oil-paper insulating system;
Fig. 2 shows the charging with direct voltage U_{c} for a time of t_{c}, the discharging with a time of t_{d}, and the time-function of the subsequent recovery voltage as it appears;
Fig. 3 illustrates the dependence of Dᵣ, the ratio of development of the elementary polarization processes, characterized by a time constant T, the charging time t_{c} and the discharging time t_{d};
Fig. 4 illustrates the dependence of Dᵣ, the ratio of development of the elementary polarization processes, characterized by the time constant T, and the ratio of charging time - discharging time, t_{c}/t_{d};
Fig. 5 shows the polarization distributions of oil-paper insulating systems
   a. in a new state, and
   b. in an aged state;
Fig. 6 illustrates the ratio of the recovery voltage peak value (Uₘ) to charging voltage (U_{c}) as a function of time T at various insulating paper humidity values, in the case of oil-paper insulating systems;
Fig. 7 shows the measured recovery voltage peak (Uₘ) - charging voltage (U_{c}) ratio distribution, measured on high voltage transformers of various age, with differently aged oil-paper insulating systems;
Fig. 8 shows the distributions of the initial slope of the recovery voltage (Mᵣ = tgαᵣ), measured on the same transformers as in Fig. 7; and
Fig. 9 shows the recovery voltage peak value (Uₘ) - charging voltage (U_{c}) ratio distribution for a high voltage transformer with an oil-paper insulation system, after a breakdown.

An examination of the absorption coefficient K_{A} illustrated in Fig. 1 for the case of insulating paper as a function of the moisture content and temperature shows that the K_{A} measurement in widespread use does not give unambiguous information relating the condition of the insulating system. The changes of K_{A} as a function of humidity and temperature are not of a monotonous character.

Figs. 2, 3 and 4 show the basic principles of the test measurement of the recovery voltages. Fig. 2 shows primarily the basic ideas.

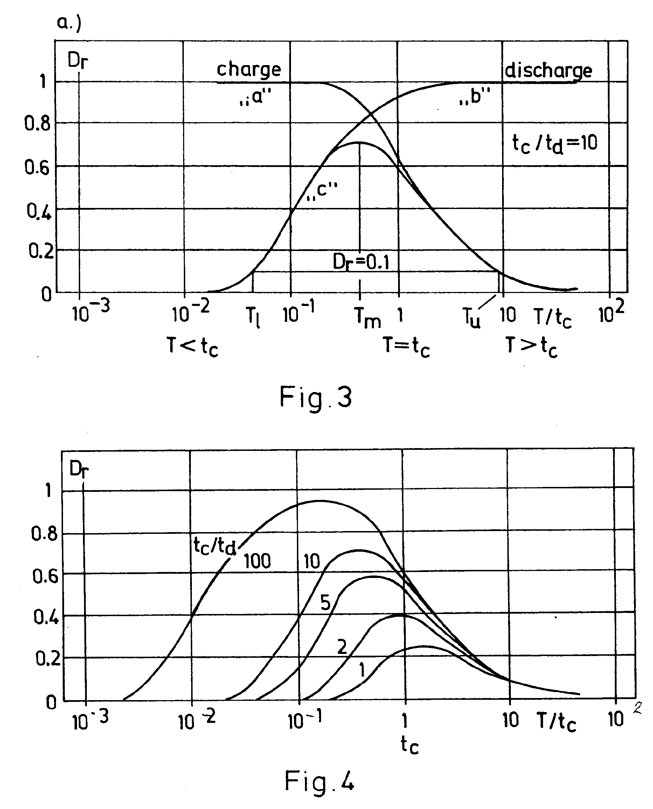

The curve "a" of Fig. 3 shows the development ratio Dᵣ of those elementary polarization processes, characterized with a time-constant T, which are activated in the charging period t_{c}.

It can be seen that in the case of T < t_{c}, the polarization processes develop practically totally, i.e. Dᵣ = 1. Concretely: in the case of T=0.45 t_{c}, Dᵣ = 0.9 and, in the case of T > t_{c}, the development is small, concretely: in the case of T = 10t_{c}, Dᵣ = 0.1

The curve "b" of the Fig. 3 shows the likely regression during the short-circuit or discharge period t_{d}. Finally the curve "c" of Fig. 3 shows the resultant, i.e. to what degree, expressed as the value of Dᵣ the elementary polarization processes are in an activated state.

Fig. 4 shows the relation of the selection of the ratio t_{c}/t_{d} and the activation of the elementary polarization processes after charging, that is, when the recovery voltage appears. It can be seen in Fig. 4 that the selection of t_{c}/t_{d} is determined by a compromise between the sensitivity of the recovery voltage measurement, and the selectivity requirement of the determination of the individual polarization ranges.

The range of t_{c}/t_{d} = 0.1...100 includes the practical cases.

By selecting t_{c}/t_{d} = 2, the central time-constant Tₘ would be the same as the charging period. For other t_{c}/t_{d} values Tₘ would be Tₘ = kt_{c}, where the value of k is determined by the "centre of gravity" of the area under the curve "c" in Fig. 3.

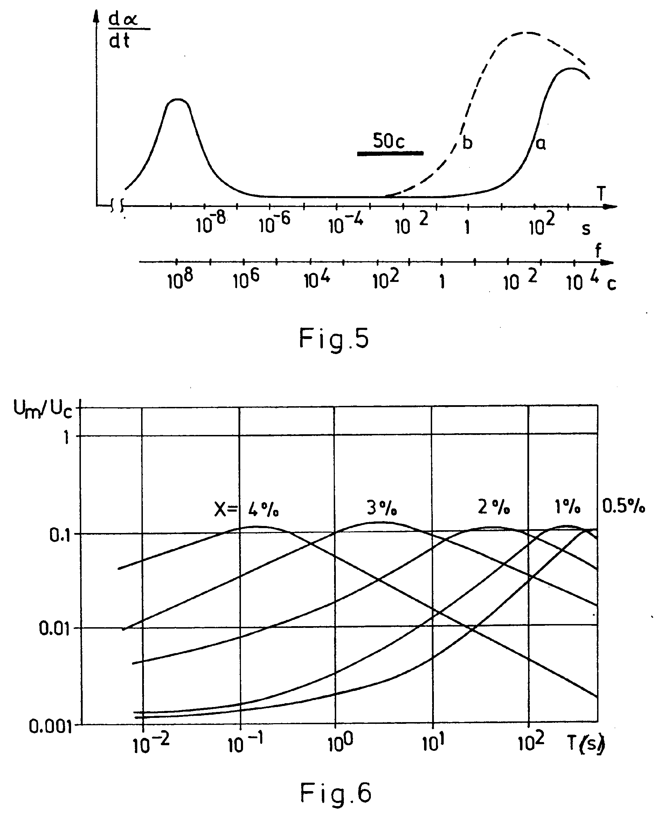

Fig. 5 shows that the polarization distribution of oil-paper insulating systems is shifted toward the region which can be tested by DC and low frequency voltage in case of ageing of the insulating system. It can be said that the interval near 50 Hz would only be activated by very badly aged insulating systems.

This is the reason of the low diagnostic sensitivity of tgδ measurement at 50 Hz.

Fig. 5 shows at the same time that the time-constant range of 10⁻³ - 10⁴ s includes with great reliability all the changes generated by ageing.

Fig. 6 summarizes the test results determined by the test method according to the invention. It can be seen in Fig. 6 that the variation of the moisture content from 0.5% to 4% results in an unambiguous change of the distributions. The dominant time-constant, which refers to the peak value of the ratio Uₘ/U_{c} in the said moisture content range of 0.5-4%, changes by more than 3 orders of magnitude for the individual moisture content values.

This testing method responds therefore very sensitively and reliably to the ageing of insulating systems. The 0.5 % moisture content and the respective dominant central time-constant of about 500 s charactize a good insulating system. The operation of an insulation system with more than 3% moisture content, or with less than 1 s as the dominant central time-constant, is problematical as the risk of a breakdown exists. At moisture contents under 1-1.5%, there is no significant moisture-caused polarization in the time range of 0.01 - 100 s. In this case, the accumulation of the ageing products can be following from the changing of the central time-constants.

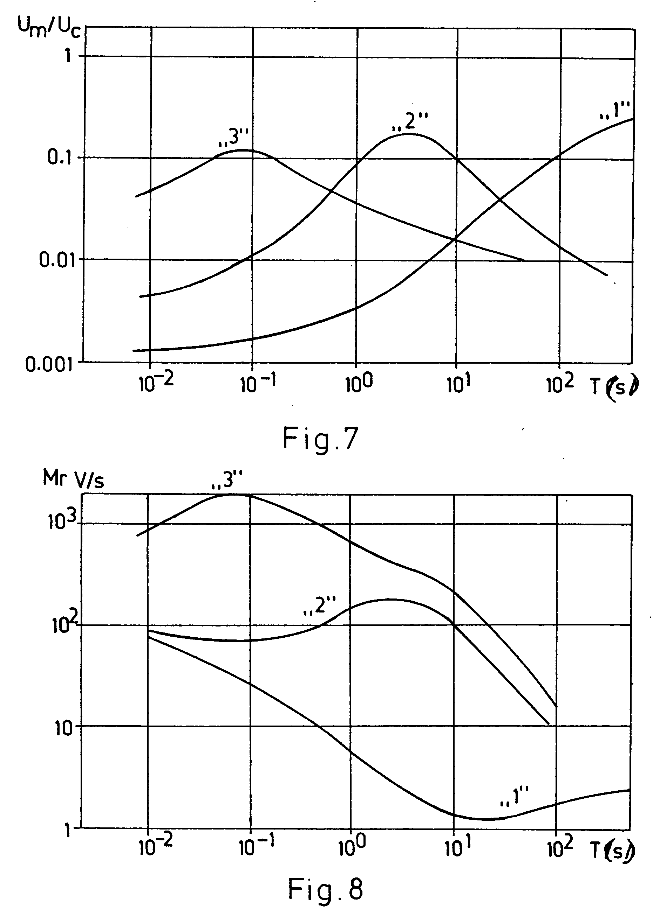

Fig. 7 shows further the usefulness of the process according to the invention. The distribution denoted with "1" in Fig. 7 was measured on a new 765/410 kV transformer. The curve denoted with "2" is a distribution of a 15-year old 120/20 kV transformer, wherein the central time-constant allows one to deduce, after taking into account the information given in Fig. 6, that the moisture content is 3%. This transformer needs an oil treatment, for reducing the humidity content. The curve designated with "3" shows an aged transformer, the dominant central time-constant under 0.1 s infers a humidity content of more than 4%. The nominal voltage of the transformer was 35/20kV, the operating temperature was mostly under 40°C; this unit could be operated only at these low electrical and thermal loads.

Fig. 8 gives the distributions of the initial slopes of the recovery voltages (Mᵣ = tgαr, see Fig. 2), for the transformers of Fig. 7. The conclusions from Fig. 7 are also valid for Fig. 8.

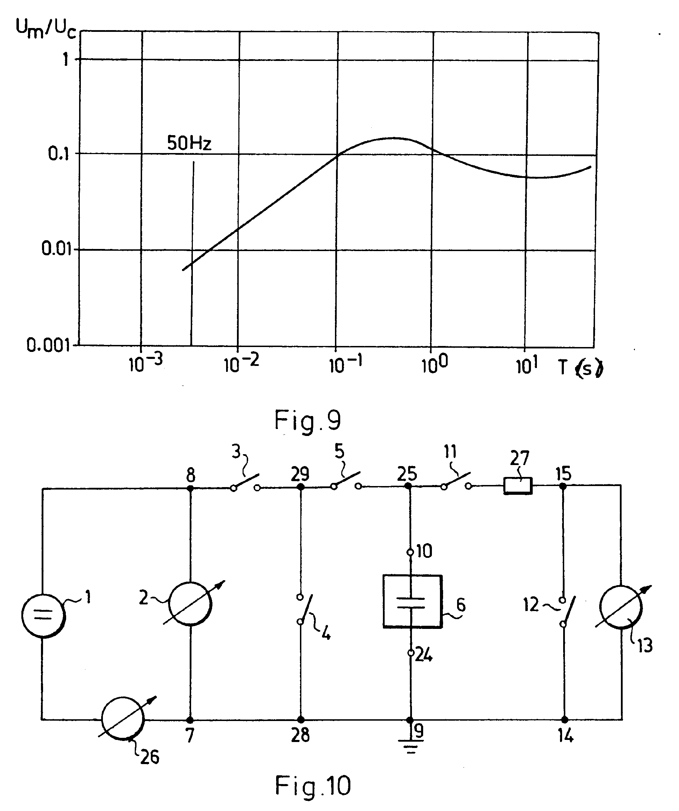

Fig. 9 gives the results of measurements on a 120/20 kV transformer that had a breakdown during operation at a temperature of 60°C. The measurements were carried out at a temperature of 20°C. The dominant central time-constant measured at 60°C would be about one order of magnitude less than at 20°C. It would therefore approach the time interval which determines dielectric losses at 50 Hz.

Hereafter, the testing apparatus implementing the method according to the invention will be described in detail with the aid of the examples shown in the enclosed drawings.

Fig. 10 shows the recovery voltage measuring circuit diagram.

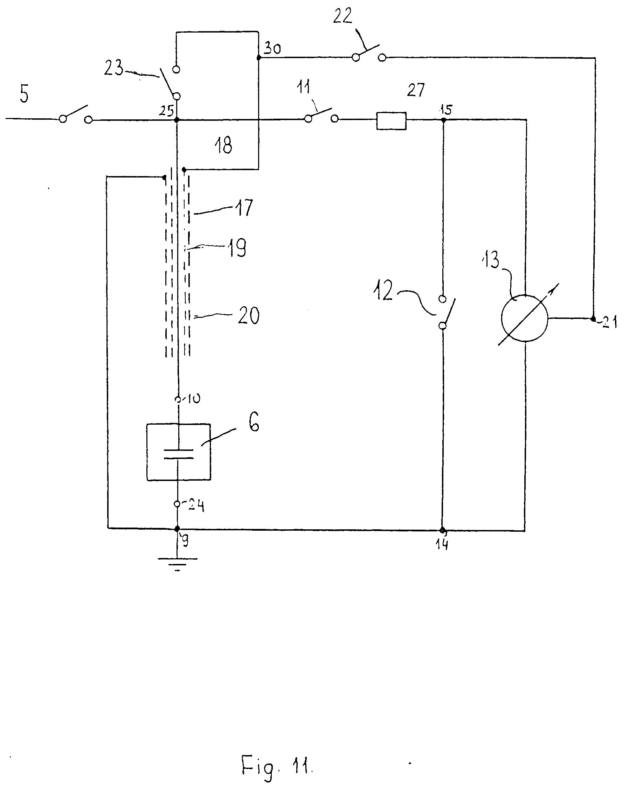

Fig. 11 shows an advantageous circuit arrangement between the test circuit and the test object, i.e the insulating system to be tested.

Fig. 10 shows a circuit diagram, wherein the testing apparatus consisting of a high voltage source 1, voltage meters 2 and 13, a current meter 26, a switching network with elements 3, 4, 5, 11 and 12, and the system to be tested, which is simulated by a capacitor 6.

One terminal 7 of the high voltage source 1 is common with a terminal (earthed) 9 of the measuring terminals of the tested apparatus, and is directly connected to one of the electrodes 24 of the insulating system 6 under test. The other terminal 8 of source 1 is connected via at least two series-connected switches 3, 5 to another measuring terminal 25 to which the other electrode 10 of the insulating system 6 is connected. The first switch 3 is shunted by a switch 4 in a cross-line between the measuring terminal 8 and the common point 29 of the switches 3, 5. A recovery voltage measuring unit 13 has one terminal 14 connected to the measuring terminal 9, while its other terminal 15 connects through at least one serial switch 11 and a load 27 to the other measuring terminal 25. A cross-line switch 12 shunts the voltage measuring unit 13. In one possible design, the switches are operated by electromagnets, for example, the switches are high voltage reed-relays, in another design they are solid state switches.

The design shown in Fig. 11 is a diagram of the circuit between the measuring terminal 25 and the electrode 10, of insulation system 6, including a double-screened cable 17 with an inner lead or conductor 18. The voltage metering unit 13 consists of an electrometer circuit. Its terminal 21 is connected to the inner shielding 19 of the cable 17 via a series switch 22. The outer shielding 20 is earthed.

This shielded connection is advantageous for eliminating external interferences, while at the same time the inner shielding of this design assures that the currents arising from the cable capacitance of the insulating do not load the capacitance of system 6, whereby to increase the accuracy of the measurement.

The current meter 26 shown in Fig. 10 makes it possible to measure the current during the charging period, and then to determine the insulating resistance by itself and as a function of time, by measuring with the voltage meter 2 the ratio of the current and the charging voltage. If the charging period is greater than 1 min, then there is the additional possibility of determining K_{A} = R₆₀/R₁₀, with the same testing apparatus.

The design of the voltage meter 13 of the testing apparatus (electrometer input) provides an input impedance greater than 2x10¹³ ohm. This design ensures the accuracy of the measurement also in the case of an insulation system of good quality/condition.

## Claims

1. A process for testing the condition of an insulating system, comprising charging the insulating system with a direct charging voltage through insulated, electrically conducting parts, then discharging the insulating system, and determining the condition of the insulating system from the parameters of the recovery voltage, characterised by selecting the duration of charging to be in the range of 10⁻³ - 10⁴s and the ratio of charging period to discharging period to be in the range of 0.1 to 100, measuring the ratio of the peak value of the recovery voltage to the charging voltage, and then repeating the measurement with different durations, but a constant ratio, of the charging-discharging periods, determining the distribution of the said voltage ratios as a function of the charging period, and determining the state of the insulating system by comparing the thus obtained distribution with a reference distribution.

2. A process according to claim 1, characterised by additionally determining the initial slope of the recovery voltage as a function of the charging period, and establishing further the state of the insulating system by comparing the distribution obtained in this way with a further reference distribution.

3. A process according to claim 2 characterised by obtaining the initial slope of the recovery voltage by voltage sampling with a sampling periodicity equal to that, or an integer multiple, of the mains AC voltage frequency.

4. A process according to any preceding claim, characterised by additionally measuring the charging current as a function of the charging period, and determining the variation with time of the insulating resistance of the insulating system.

5. Apparatus for carrying out the process according to any of claims 1 to 4, comprising a high voltage source (1) and a voltage measuring circuitry, one voltage terminal (7) of the high voltage source (1) being connected to a first measurement terminal (9) of the apparatus while the other voltage terminal (8) of the high voltage source is connected via a first serial branch switch (3) to a second measurement terminal (25) thereof, and the voltage measuring circuitry including a recovery voltage measuring unit (13) connected via one of its connection terminals (14) to the first measurement terminal (9), which first measurement terminal (9) is connected or connnectable to a first insulated, electrically conducting part (24) of the insulating system (6) to be tested, characterised in that another insulated, electrically conducting part (10) of the insulating system (6) is connected to the second measurement terminal (25), the other voltage terminal (8) of the high voltage source being connected to the second measurement terminal (25) via the first and a second serial branch switch (3,5); in that a transverse shunt switch (4) is inserted after the first serial branch switch (3) between the first measurement terminal (9) and a common node (29) of the two serial branch switches (3,5); in that the other connection terminal (15) of the measuring unit (13) is connected, preferably via at least one further serial branch switch (11), to the second measurement terminal (25); in that a further transverse shunt switch (12) is connected in parallel with said measuring unit (13); and in that, preferably, the said switches (3, 4, 5, 11, 12) are solid state switches.

6. Apparatus according to claim 5, characterised in that the connection of the said second measurement terminal (25) and the said other electrically conducting part (10) of the said insulating system (6) is effected by means of the inner lead (18) of a double-screened cable (17); and in that said measuring unit (13) consists of an electrometer circuit, an outlet (21) of which is connected via a series switch (22) to the inner shield (19) of said cable (17) with the other shield (20) of said cable (17) being connected to earth potential.

7. Apparatus according to claim 6, characterised in that a switch (23) is connected between the inner shield (19) and the inner lead (18).

8. Apparatus according to any of claims 5 to 7, characterised in that the input impedance of the measuring unit (13) is at least 2 x 10¹³ohm.

9. Apparatus according to any one of claims 5 to 8, characterised in that a current meter unit (26) is connected between the high voltage source (1) and the said first measurement terminal (9).

## Patentansprüche

1. Verfahren zum Untersuchen des Zustandes eines Isoliersystems, bei dem das Isoliersystem mit einer Gleichladespannung über isolierte, elektrisch leitende Teile geladen wird, dann das Isoliersystem entladen wird, und der Zustand des Isoliersystems aus den Parametern der Wiederkehrspannung bestimmt wird, dadurch gekennzeichnet, daß die Ladedauer in dem Bereich von 10⁻³ - 10⁴ s und das Verhältnis der Ladezeit zu der Entladezeit in dem Bereich von 0.1 bis 100 gewählt werden, das Verhältnis des Spitzenwertes der Wiederkehrspannung zu der Ladespannung gemessen wird, und dann die Messung mit unterschiedlicher Dauer, jedoch einem konstanten Verhältnis der Lade-Entlade-Zeiten wiederholt wird, der Verlauf der Spannungsverhältnisse in Abhängigkeit von der Ladezeit bestimmt wird, und der Zustand des Isoliersystems durch Vergleichen des derart erhaltenen Verlaufs mit einem Referenzverlauf bestimmt wird.

2. Verfahren nach Anspruch 1, dadurch gekennzeichnet, daß zusätzlich die Anfangssteilheit der Wiederkehrspannung in Abhängigkeit von der Ladezeit bestimmt wird und weiter der Zustand des Isoliersystems durch Vergleichen des in dieser Weise erhaltenen Verlaufs mit einem weiteren Referenzverlauf bestimmt wird.

3. Verfahren nach Anspruch 2, dadurch gekennzeichnet, daß die Anfangssteilheit der Wiederkehrspannung mithilfe eines Spannungsabtastens mit einer Abtastfrequenz erhalten wird, die gleich oder ein ganzzahliges Mehrfaches der Frequenz der AC-Netzspannung ist.

4. Verfahren nach einem der vorangehenden Ansprüche, dadurch gekennzeichnet, daß zusätzlich der Ladestrom in Abhängigkeit von der Ladezeit gemessen wird und die zeitliche Änderung des Isolierwiderstandes des Isoliersystems bestimmt wird.

5. Vorrichtung zum Durchführen des Verfahrens nach einem der Ansprüche 1 bis 4, mit einer Hochspannungsquelle (1) und einem Spannungsmeßschaltkreis, wobei der eine Spannungsanschluß (7) der Hochspannungsquelle (1) an einen ersten Meßanschluß (9) der Vorrichtung angeschlossen ist und der andere Spannungsanschluß (8) der Hochspannungsquelle über einen ersten seriellen Zweigschalter (3) an einen zweiten Meßanschluß (25) derselben angeschlossen ist, und der Spannungsmeßschaltkreis eine Wiederkehrspannungs-Meßeinheit (13) umfaßt, welche über einen ihrer Verbindungsanschlüsse (14) an den ersten Meßanschluß (9) angeschlossen ist, der an einen ersten isolierten elektrisch leitenden Teil (24) des zu untersuchenden Isoliersystems (6) angeschlossen oder anschließbar ist, dadurch gekennzeichnet, daß ein anderer isolierter, elektrisch leitender Teil (10) des Isoliersystems (6) an den zweiten Meßanschluß (25) angeschlossen ist, der andere Spannungsanschluß (8) der Hochspannungsquelle an den zweiten Meßanschluß (25) über den ersten und einen zweiten seriellen Zweigschalter (3, 5) angeschlossen ist; daß ein querverlaufender Kurzschlußschalter (4) hinter dem ersten seriellen Zweigschalter (3) zwischen dem ersten Meßanschluß (9) und einem gemeinsamen Knotenpunkt (29) der beiden seriellen Zweigschalter (3, 5) eingefügt ist; daß der andere Verbindungsanschluß (15) der Meßeinheit (13) an den zweiten Meßanschluß (25), bevorzugt über wenigstens einen weiteren seriellen Zweigschalter (11), angeschlossen ist; daß ein weiterer querverlaufender Kurzschlußschalter (12) zu der Meßeinheit (13) parallelgeschaltet ist; und daß die Schalter (3, 4, 5, 11, 12) bevorzugt Festkörperschalter sind.

6. Vorrichtung nach Anspruch 5, dadurch gekennzeichnet, daß die Verbindung des zweiten Meßanschlusses (25) und des anderen elektrisch leitenden Teiles (10) des Isoliersystems (6) mit Hilfe einer Innenleitung (18) eines doppelt abgeschirmten Kabels (17) ausgeführt ist; und daß die Meßeinheit (13) aus einem Elektrometerschaltkreis besteht, dessen einer Ausgang (21) über einen seriellen Schalter (22) an die Innenabschirmung (19) des Kabels (17) angeschlossen ist, wobei die Außenabschirmung (20) des Kabels (17) an Erdpotential geschaltet ist.

7. Vorrichtung nach Anspruch 6, dadurch gekennzeichnet, daß ein Schalter (23) zwischen die Innenabschirmung (19) und die Innenleitung (18) geschaltet ist.

8. Vorrichtung nach einem der Ansprüche 5 bis 7, dadurch gekennzeichnet, daß die Eingangsimpedanz der Meßeinheit (13) wenigstens 2·10¹³ Ohm ist.

9. Vorrichtung nach einem der Ansprüche 5 bis 8, dadurch gekennzeichnet, daß eine Strommeßeinheit (26) zwischen die Hochspannungsquelle (1) und den ersten Meßanschluß (9) geschaltet ist.

## Revendications

1. Un procédé de test de la situation d'un système d'isolation comprenant les étapes consistant à charger le système d'isolation avec une tension continue de charge via des parties électriquement conductrices et isolées, puis à décharger le système d'isolation, et à déterminer la situation du système d'isolation à partir des paramètres de la tension de récupération, caractérisé en ce que l'on choisit la durée de charge dans une gamme de 10⁻³ à 10⁴s et le rapport entre la période de charge et la période de décharge dans une gamme de 0,1 à 100; l'on mesure le rapport entre la valeur de crête de la tension de récupération et la tension de charge, et l'on répète ensuite la mesure pour des durées différentes mais avec un rapport constant entre les périodes de charge et de décharge; l'on détermine la distribution desdits rapports de tension en fonction de la période de charge et l'on détermine l'état du système d'isolation grâce à la comparaison de la distribution ainsi obtenue avec une distribution de référence.

2. Un procédé selon la revendication 1, caractérisé en ce que l'on détermine également la pente initiale de la tension de récupération en fonction de la période de charge, et l'on établit en outre l'état du système d'isolation en comparant la distribution obtenue de cette manière avec une distribution supplémentaire de référence.

3. Un procédé selon la revendication 2, caractérisé en ce que l'on obtient la pente initiale de la tension de récupération par un échantillonnage de tension dont la périodicité d'échantillonnage est égale à celle ou bien est un multiple entier de fréquence de la tension en courant alternatif du secteur.

4. Un procédé selon l'une quelconque des revendications précédentes, caractérisé en ce que l'on mesure en outre le courant de charge en fonction de la période de charge et on détermine la variation en fonction du temps de la résistance d'isolation du système isolant.

5. Dispositif pour mettre en oeuvre le procédé selon l'une quelconque des revendications 1 à 4, comprenant une source à tension élevée (1) et un circuit de mesure de tension, l'une des bornes de tension (7) de la source à tension élevée (1) étant raccordée à une première borne de mesure (9) du dispositif tandis que l'autre borne de tension (8) de la source à tension élevée est raccordée, via un premier interrupteur monté en série (3) à une deuxième borne de mesure (25) du dispositif, et le circuit de mesure de tension comprenant une unité de mesure de tension de récupération (13) raccordée via l'une de ses bornes de raccordement (14) à la première borne de mesure (9), cette première borne de mesure (9) étant raccordée, ou susceptible d'être raccordée, à une première partie électriquement conductrice et isolée (24) du système d'isolation (6) à tester, caractérisé en ce qu'une autre partie électriquement conductrice et isolée (10) du système d'isolation (6) est raccordée à la deuxième borne de mesure (25), l'autre borne de tension (8) de la source à tension élevée étant raccordée à la deuxième borne de mesure (25) via le premier ainsi qu'un deuxième interrupteurs montés en série (3, 5); en ce qu'un interrupteur en shunt transversal(4) est inséré après le premier interrupteur monté en série (3), entre la première borne de mesure (9) et un noeud commun (29) des deux interrupteurs montés en série (3, 5); en ce que l'autre borne de raccordement (15) de l'unité de mesure (13) est raccordée, de préférence via au moins un autre interrupteur monté en série (11), à la deuxième borne de mesure (25); en ce qu'un autre interrupteur en shunt transversal (12) est raccordé en parallèle à ladite unité de mesure (13); et en ce que, de préférence, lesdits interrupteurs (3, 4, 5, 11, 12) sont des interrupteurs à semi-conducteur.

6. Dispositif selon la revendication 5, caractérisé en ce que le raccordement de ladite deuxième borne de mesure (25) et de l'autre partie électriquement conductrice (10) dudit système d'isolation (6) est réalisée au moyen du conducteur interne (18) d'un câble à double blindage (17); et en ce que ladite unité de mesure (13) comprend un circuit d'électromètre dont une sortie (21) est raccordée, via un interrupteur en série (22), au blindage interne (19) dudit câble (17), l'autre blindage (20) dudit câble (17) étant raccordé au potentiel de la masse.

7. Dispositif selon la revendication 6, caractérisé en ce qu'un interrupteur (23) est raccordé entre le blindage interne (19) et le conducteur intérieur (18).

8. Dispositif selon l'une quelconque des revendications 5 à 7, caractérisé en ce que l'impédance d'entrée de l'unité de mesure (13) est d'au moins 2 x 10¹³ ohms.

9. Dispositif selon l'une quelconque des revendications 5 à 8, caractérisé en ce qu'une unité de mesure de courant (26) est raccordée entre la source à tension élevée (1) et ladite première borne de mesure (9).
